# EUROPÄISCHE PATENTSCHRIFT

(11) **EP 2 795 720 B1**
(45) Veröffentlichungstag und Bekanntmachung des Hinweises auf die Patenterteilung: **26.08.2020**
(21) Anmeldenummer: 12783939.7
(22) Anmeldetag: 30.10.2012
(51) Int. Cl.: H01Q 1/12, H03K 17/96

(54) **VERBUNDSCHEIBE MIT ANTENNENSTRUKTUR UND INTEGRIERTER SCHALTFLÄCHE**
COMPOUND GLAZING WITH ANTENNA STRUCTURE AND INTEGRATED BUTTON
PLAQUE COMPOSITE DOTÉE D'UNE STRUCTURE D'ANTENNE ET D'UNE SURFACE DE COMMUTATION INTÉGRÉE

(30) Priorität: 20.12.2011 EP 11194451
(43) Veröffentlichungstag der Anmeldung: 29.10.2014
(73) Patentinhaber: SAINT-GOBAIN GLASS FRANCE, 92400 Courbevoie (FR)
(72) Erfinder: SCHMALBUCH, Klaus, 84220 Goult (FR)
(74) Vertreter: Gebauer, Dieter Edmund
(86) Internationale Anmeldenummer: PCT/EP2012/071424
(87) Internationale Veröffentlichungsnummer: WO 2013/091961

(56) Entgegenhaltungen:
- EP-A1- 0 004 001
- WO-A1-2011/036010
- US-A- 5 898 407
- US-A1- 2005 115 308
- US-A1- 2008 202 912
- US-A1- 2009 128 431
- US-B1- 6 794 728

## Beschreibung

Die Erfindung betrifft eine Verbundscheibe mit Antennenstruktur und integrierter Schaltfläche, ein Verfahren zu deren Herstellung und deren Verwendung.

Das Verdeck eines Cabriolets kann beispielsweise als Stoff-Verdeck oder als zusammenklappbares Metalldach ausgestaltet sein. Das Verdeck kann durch Zurückklappen geöffnet werden. Das Öffnen des Verdecks kann dabei manuell erfolgen. Dies ist jedoch für den Benutzer unkomfortabel, kann zu Verletzungen, beispielsweise Quetschungen führen und ist insbesondere für schwächere Personen benutzerunfreundlich. Cabriolet-Verdecke können auch über einen elektrischen Öffnungsmechanismus angesteuert werden, der typischerweise durch einen Schalter am Armaturenbrett bedient wird. Die Integration einer Vielzahl von Schaltern bei modernen Fahrzeugen führt jedoch zu einem überfüllten Armaturenbrett, was eine intuitive Bedienung des Cabriolet-Verdecks erschwert.

Das Verdeck eines Cabriolets kann nicht zur Befestigung von Antennen genutzt werden. Daher sind Antennenstrukturen typischerweise für den Betrachter unsichtbar in die Windschutzscheibe von Cabriolets integriert. Die Antennenstrukturen können beispielsweise durch dünne Drähte realisiert sein, die in die thermoplastische Zwischenschicht der Verbundglasscheibe eingelagert sind. Solche Lösungen sind beispielsweise aus EP 0004001 A1, DE 2529994 B2, DE 2440439 A1 und DE 2360672 B2 bekannt. Die Antennenstrukturen können alternativ durch Aufdrucken und Einbrennen einer elektrisch leitfähigen Paste realisiert werden, was beispielsweise aus WO 2009038546 A1, EP 396033 B1, DE 10333620 A1, DE 10319607 B3 und DE 4237818 A1 bekannt ist. Antennenstrukturen können auch durch typischerweise aufgedampfte oder aufgesputterte elektrisch leitfähige Beschichtungen realisiert werden, was beispielsweise aus DE 102008027371 A1, DE 19832228 A1 oder DE 19735395 A1 bekannt ist.

Es ist auch bekannt, dass Schaltflächen in eine Verglasung integriert werden können, beispielsweise als kapazitive Schaltflächen. Das Einbringen oder Aufbringen der dafür notwendigen Elektroden ist jedoch mit aufwendigen und kostenintensiven Herstellungsverfahren verbunden. Weiterer Stand der Technik kann WO 2011036010 A1, US 2005115308 A1, US 2008202912 A1 und US 6794728 B1 entnommen werden.

Eine Aufgabe der vorliegenden Erfindung ist es, eine Verbundscheibe mit Antennenstruktur und integrierter Schaltfläche bereitzustellen, die einfach und kostengünstig hergestellt werden kann. Eine weitere Aufgabe der vorliegenden Erfindung ist es, ein Verfahren zur Herstellung einer Verbundscheibe mit Antennenstruktur und integrierter Schaltfläche bereitzustellen.

Die Aufgabe der vorliegenden Erfindung wird erfindungsgemäß durch eine Verbundscheibe mit Antennenstruktur und integrierter Schaltfläche gemäß dem unabhängigen Anspruch 1 gelöst. Bevorzugte Ausführungen gehen aus den Unteransprüchen hervor.

Die erfindungsgemäße Verbundscheibe mit Antennenstruktur und integrierter Schaltfläche aus einer Außenscheibe mit einer Außenfläche und einer Innenfläche, einer Innenscheibe mit einer Innenfläche und einer Außenfläche und einer thermoplastischen Zwischenschicht umfasst zumindest die folgenden Merkmale:
- eine erste elektrisch leitfähige Struktur, die ein Antennenleiter ist, und
- eine zweite elektrisch leitfähige Struktur, die eine Schaltfläche ist,
wobei die erste elektrisch leitfähige Struktur und die zweite elektrisch leitfähige Struktur auf der Außenfläche der Außenscheibe, auf der Innenfläche der Außenscheibe, auf der Innenfläche der Innenscheibe, auf der Außenfläche der Innenscheibe oder in der thermoplastischen Zwischenschicht angeordnet sind und als Drähte, als aufgedruckte leitfähige Strukturen oder als transparente leitfähige Beschichtungen ausgebildet sind.

Mit Innenflächen werden im Sinne der Erfindung die Oberflächen der Außenscheibe und der Innenscheibe bezeichnet, die zur thermoplastischen Zwischenschicht hingewandt sind. Mit Außenflächen werden im Sinne der Erfindung die Oberflächen der Außenscheibe und der Innenscheibe bezeichnet, die von der thermoplastischen Zwischenschicht abgewandt sind.

Die zweite elektrisch leitfähige Struktur ist erfindungsgemäß eine Schaltfläche, insbesondere eine berührungslose Schaltfläche. Dadurch wird an zumindest einer Außenfläche der Außenscheibe und / oder der Innenscheibe im Bereich der zweiten elektrisch leitfähigen Struktur eine Schaltfläche ausgebildet.

Die erste elektrisch leitfähige Struktur und die zweite elektrisch leitfähige Struktur sind erfindungsgemäß nach dem gleichen technischen Prinzip realisiert. Sowohl die erste elektrisch leitfähige Struktur als auch die zweite elektrisch leitfähige Struktur sind entweder als dünne Drähte oder als aufgedruckte leitfähige Strukturen oder als transparente leitfähige Beschichtungen realisiert.

Die erste elektrisch leitfähige Struktur und die zweite elektrisch leitfähige Struktur sind erfindungsgemäß auf der gleichen Oberfläche der gleichen Scheibe der Verbundscheibe oder in der thermoplastischen Zwischenschicht angeordnet.

Der besondere Vorteil der Erfindung liegt in der Realisierung der ersten und der zweiten elektrisch leitfähigen Struktur nach dem gleichen technischen Prinzip und der Anordnung der ersten und der zweiten elektrisch leitfähigen Struktur. Bei der Herstellung einer Scheibe mit integrierter Antennenfunktion, beispielsweise einer Windschutzscheibe für ein Cabriolet kann einfach und kostengünstig eine Schaltfläche integriert werden. Durch die erfindungsgemäße Ausgestaltung und Anordnung der zweiten elektrisch leitfähigen Struktur wird der technische und finanzielle Mehraufwand zur Integration der Schaltfläche minimiert.

Die erste elektrisch leitfähige Struktur mit Antennenfunktion ist als Antennenleiter bevorzugt linienförmig ausgestaltet. Die Länge des Antennenleiters wird durch die zu erzielende Antennencharakteristik bestimmt. Antennenleiter können als Linien mit offenem oder geschlossenem Ende ausgeführt sein, oder unterschiedliche Formen, Anordnungen und Zwischenverbindungen aufweisen und beispielsweise rund, spiralförmig oder mäanderförmig ausgestaltet sein.

Die Antennencharakteristik wird durch die empfangenen oder zu sendenden Frequenzen bestimmt. Es handelt sich bei der empfangenen und / oder ausgesendeten elektromagnetischen Strahlung bevorzugt um LF-, MF-, HF-, VHF-, UHF- und / oder SHF-Signale im Frequenzbereich von 30 kHz bis 10 GHz, besonders bevorzugt um Radiosignale, insbesondere UKW (30 MHz bis 300 MHz, entsprechend einer Wellenlänge von 1 m bis 10 m), Kurzwelle (3 kHz bis 30 MHz, entsprechend einer Wellenlänge von 10 m bis 100 m) oder Mittelwelle (300 kHz bis 3000 kHz, entsprechend einer Wellenlänge von 100 m bis 1000 m), sowie Signale der Mauterfassung, des Mobilfunks, Digitalradios, Fernsehsignale oder Navigationssignale. Die Länge der Antennenleiters beträgt bevorzugt ein Vielfaches oder einen Bruchteil der Wellenlänge der zu übertragenden Frequenzen, insbesondere die Hälfte oder ein Viertel der Wellenlänge. Zur besseren Ausnutzung der Scheibenoberfläche können die Antennenleiter gekrümmt, mäanderförmig oder spiralförmig ausgestaltet sein.

Der Antennenleiter kann alternativ aber auch als Flächenantenne ausgestaltet sein, insbesondere wenn die zweite elektrisch leitfähige Struktur als transparente leitfähige Beschichtung realisiert ist.

Der Antennenleiter weist einen Anschlusspunkt auf, über den der Antennenleiter mit einem Empfangsgerät mittels eines Leiters, bevorzugt eines Flachleiters verbunden ist. Der Leiter kann galvanisch, beispielsweise durch Löten, Schweißen, Klemmen oder über einen elektrisch leitfähigen Kleber, oder kapazitiv, beispielsweise über eine isolierende Zwischenschicht, mit dem Anschlusspunkt des Antennenleiters verbunden sein.

Die elektrisch leitfähige Struktur kann auch mehrere Antennenleiter ausbilden, beispielsweise mehrere Antennenleiter unterschiedlicher Ausdehnung zur Abdeckung unterschiedlicher Frequenzbereiche. Die Antennenleiter können in einem gemeinsamen Anschlusspunkt zusammenlaufen oder über eine gemeinsame Stromsammelschiene kontaktiert sein, die einen Anschlusspunkt umfasst. Typische Breiten von Stromsammelschienen betragen von 3 mm bis 30 mm.

Die Schaltfläche ist bevorzugt eine kapazitive Schaltfläche. In einer vorteilhaften Ausgestaltung bildet die zweite elektrisch leitfähige Struktur dabei eine Flächenelektrode aus. Über eine externe Steuerungselektronik wird die Kapazität der Flächenelektrode gemessen. Die Kapazität der Flächenelektrode ändert sich gegen Erde, wenn ein geerdeter Körper in ihre Nähe kommt oder beispielsweise eine Isolatorschicht über der Flächenelektrode berührt. Die Kapazitätsänderung wird durch die Steuerungselektronik gemessen und bei Überschreiten eines Schwellwerts wird ein Schaltsignal ausgelöst. Die Schaltfläche wird durch Form und Größe der Flächenelektrode festgelegt.

In einer alternativen vorteilhaften Ausgestaltung bildet die zweite elektrisch leitfähige Struktur zwei Elektroden aus, die kapazitiv miteinander gekoppelt sind. Die Elektroden können beispielsweise spiralartige, kammartige oder mäanderartige Formen aufweisen. Die Kapazität des von den Elektroden gebildeten Kondensators ändert sich bei Annäherung eines Körpers. Die Kapazitätsänderung wird durch die Steuerungselektronik gemessen und bei Überschreiten eines Schwellwerts wird ein Schaltsignal ausgelöst. Die Schaltfläche wird durch Form und Größe des Bereichs, in denen die Elektroden kapazitiv gekoppelt sind, festgelegt.

Die Verbindung jeder von der zweiten elektrisch leitfähigen Struktur gebildeten Elektrode mit der externen Steuerungselektronik und Spannungsversorgung erfolgt über einen Leiter, bevorzugt einen Flachleiter, der bevorzugt im Randbereich der Verbundscheibe mit der zweiten elektrisch leitfähigen Struktur galvanisch verbunden ist, beispielsweise durch Löten, Klemmen oder mittels eines elektrisch leitfähigen Klebstoffs. Dazu ist bevorzugt ein Bereich jeder durch die zweite elektrisch leitfähige Struktur gebildeten Elektrode zur Scheibenkante geführt. Dadurch können auf einfache Weise und für den Benutzer kaum sichtbar die Kontakte aus der Verbundscheibe heraus geführt werden. Der Randbereich der Verbundscheibe, in dem der Leiter mit der zweiten elektrischen Struktur kontaktiert ist, kann beispielsweise durch einen Rahmen, sonstige Befestigungselemente oder durch einen Abdecksiebdruck abgedeckt sein. Die Steuerungselektronik ist auf den jeweiligen Einsatzzweck abgestimmt und leitet die vorgesehene Aktion ein, wenn durch den Benutzer ein Schaltvorgang ausgelöst wird, beispielsweise das Öffnen oder Schließen einer Tür, die Inbetriebnahme eines elektrischen Geräts oder die Beheizung der Scheibe.

Erfindungsgemäße Schaltflächen sind aber nicht auf kapazitive Schaltflächen beschränkt. Die Schaltfläche kann auch induktive, thermische oder sämtliche andere Sensorfunktionen aufweisen, die berührungslos sind. Berührungslos bedeutet dabei, dass keine direkte Berührung der zweiten elektrisch leitfähigen Struktur zum Auslösen eines Schaltvorgangs notwendig ist. Natürlich ist die Schaltfunktion auch bei direkter Berührung der zweiten elektrisch leitfähigen Struktur wirksam, falls die zweite elektrisch leitfähige Struktur für den Benutzer zugänglich ist.

Die Schaltfläche kann beispielsweise die Form eines Ovals, einer Ellipse oder eines Kreises, eines Dreiecks, eines Rechtecks, eines Quadrats oder eines anders gearteten Vierecks oder eines höheren Polygons aufweisen. Die Schaltfläche weist bevorzugt eine Fläche von 0,5 cm² bis 100 cm², besonders bevorzugt von 1 cm² bis 25 cm² auf. Das ist besonders vorteilhaft im Hinblick auf eine benutzerfreundliche Bedienung der Schaltfläche sowie auf die Vermeidung von Behinderungen der Durchsicht durch die Verbundscheibe, beispielsweise durch die Markierung der Schaltfläche oder durch Fingerabdrücke im Bereich der Schaltfläche.

Die Schaltfläche ist bevorzugt im Randbereich der erfindungsgemäßen Verbundscheibe angeordnet. Die Durchsicht durch die Verbundscheibe wird somit nicht durch beispielsweise Fingerabdrücke auf der Scheibenoberfläche im Bereich der Schaltfläche oder die Markierung der Schaltfläche auf der Scheibe gestört. Der Abstand des Mittelpunkts der Schaltfläche zu einer Kante der Verbundscheibe beträgt besonders bevorzugt von 2 cm bis 20 cm, ganz besonders bevorzugt von 5 cm bis 10 cm.

Die Position der Schaltfläche auf der Verbundscheibe kann beispielsweise durch einen einlaminierten Aufkleber oder Stempel oder durch einen Aufkleber auf der außenseitigen Oberfläche einer der beiden Scheiben gekennzeichnet werden. Die Markierung enthält bevorzugt eine Form, welche die über die Schaltfläche gesteuerte Funktion beschreibt, beispielsweise ein "Plus"- oder "Minus"-Zeichen, einen Pfeil, ein oder mehrere Buchstaben und / oder Zahlen oder ein Piktogramm. Die Position der Schaltfläche kann prinzipiell auch durch Lichterscheinungen gekennzeichnet werden, beispielsweise durch über die Seitenkante in die Verglasung eingekoppeltes Licht, das an einem Lichtablenkmittel im Bereich der Schaltfläche gestreut wird, durch auf die Verbundscheibe projiziertes Licht oder durch die Emission von in die Verbundscheibe eingelagerten lumineszierenden Pigmenten, die beispielsweise durch einen Laser oder UV-Strahlungsquelle zur Lumineszenz angeregt werden.

Gemäß der Erfindung dient die zweite elektrisch leitfähige Struktur als zusätzlicher Antennenleiter. Zumindest eine der durch die zweite elektrisch leitfähige Struktur gebildeten Elektroden ist dazu zusätzlich mit einem Empfangsgerät verbunden. Ein von der Länge der Elektrode abhängiger Frequenzbereich kann somit vorteilhaft von der zweiten elektrisch leitfähigen Struktur abgedeckt werden und muss nicht von der ersten elektrisch leitfähigen Struktur abgedeckt werden.

Die erste und die zweite elektrisch leitfähige Struktur können für sich genommen opak sein, in der makroskopischen Betrachtung erscheint die Scheibe jedoch transparent.

In einer bevorzugten Ausgestaltung der Erfindung sind die erste und die zweite elektrisch leitfähige Struktur als aufgedruckte leitfähige Strukturen ausgeführt. Die leitfähigen Strukturen sind bevorzugt auf einer Oberfläche der Außenscheibe oder der Innenscheibe aufgedruckt, besonders bevorzugt auf der Innenfläche der Außenscheibe oder der Innenscheibe. Dadurch sind die erste und die zweite elektrisch leitfähige Struktur vorteilhaft vor Beschädigungen und Korrosion geschützt. Die aufgedruckten leitfähigen Strukturen enthalten zumindest ein Metall, bevorzugt Silber. Die elektrische Leitfähigkeit wird bevorzugt über Metallpartikel, enthalten in der Schicht, besonders bevorzugt über Silberpartikel, realisiert. Die Metallpartikel können sich in einer organischen und / oder anorganischen Matrix wie Pasten oder Tinten befinden, bevorzugt als gebrannte Siebdruckpaste mit Glasfritten. Die Schichtdicke der aufgedruckten leitfähigen Strukturen beträgt bevorzugt von 5 µm bis 40 µm, besonders bevorzugt von 8 µm bis 20 µm und ganz besonders bevorzugt von 10 µm bis 15 µm. Damit werden besonders gute Ergebnisse erzielt. Sind die aufgedruckten leitfähigen Strukturen linienförmig ausgestaltet, beispielsweise als Antennenleiter oder kapazitiv gekoppelte Elektroden, so betragen typische Linienbreiten von 0,1 mm bis 5 mm.

In einer besonders bevorzugten Ausgestaltung der Erfindung umfassen die erste und die zweite elektrisch leitfähige Struktur dünne Drähte, welche in die thermoplastische Zwischenschicht eingelagert sind. Der Vorteil gegenüber aufgedruckten leitfähigen Strukturen liegt in der typischerweise geringeren Breite der Drähte, so dass die erste und die zweite leitfähige Struktur für den Betrachter schwerer wahrzunehmen sind und bei Durchsicht durch die Verbundscheibe weniger störend auffallen. Die Drähte können beispielsweise vor dem Verbinden der Scheibe zur Verbundscheibe auf eine Oberfläche einer thermoplastischen Folie aufgelegt werden, welche dafür vorgesehen ist, die thermoplastische Zwischenschicht der Verbundscheibe zu bilden. Beim Herstellungsprozess der Verbundscheibe dringen die Drähte infolge von Druck und erhöhter Temperatur in die thermoplastische Zwischenschicht ein. Die Drähte können alternativ auch vor dem Verbinden der Außenscheibe und der Innenscheibe in die thermoplastische Folie eingelagert werden, beispielsweise durch Eindrücken nach Erwärmung der thermoplastischen Folie. Die Drähte können beim Herstellungsprozess der Verbundscheibe auch zwischen zwei thermoplastischen Folien positioniert werden. Die Drähte enthalten bevorzugt zumindest ein Metall, besonders bevorzugt Kupfer, Wolfram, Gold, Silber, Aluminium, Nickel, Mangan, Chrom und / oder Eisen, sowie Gemische und / oder Legierungen davon. Die Drähte weisen bevorzugt eine Dicke von 10 µm bis 300 µm, besonders bevorzugt von 20 µm bis 150 µm auf. Das ist besonders vorteilhaft im Hinblick auf die Transparenz der Verbundscheibe und die Eigenschaften der Antennenleiter beziehungsweise der Schaltfläche. Die Drähte können mit einer elektrisch isolierenden Beschichtung ausgerüstet sein.

Ist die erste Scheibe und / oder die zweite Scheibe eine polymere Scheibe, so können die Drähte prinzipiell auch in eine Oberfläche der polymeren Scheibe eingelagert werden, beispielsweise durch Ultraschall-Einbettung oder Folienhinterspritzung.

Die erste und die zweite elektrisch leitfähige Struktur können alternativ durch eine transparente elektrisch leitfähige Beschichtung realisiert sein. Die elektrisch leitfähige Beschichtung kann auf einer Oberfläche der Außenscheibe oder der Innenscheibe aufgebracht sein. Die elektrisch leitfähige Beschichtung ist bevorzugt auf der Innenfläche der Außenscheibe oder der Innenscheibe aufgebracht und ist somit vorteilhaft vor Beschädigungen oder Korrosion geschützt. Die elektrisch leitfähige Beschichtung kann aber auch auf einer Oberfläche einer dünnen Trägerfolie aufgebracht sein, die über jeweils eine thermoplastische Folie mit der Außenscheibe und mit der Innenscheibe verbunden wird. Die elektrisch leitfähige Beschichtung ist somit in die thermoplastische Zwischenschicht eingelagert, welche durch die Trägerfolie und die beiden thermoplastischen Folien gebildet wird, und ist vorteilhaft vor Beschädigungen oder Korrosion geschützt. Die Trägerfolie enthält bevorzugt zumindest ein Polyester und / oder ein Polyimid, besonders bevorzugt ein thermoplastisches Polyester, beispielsweise Polyethylennaphthalat (PEN) oder Polyethylenterephthalat (PET) und weist bevorzugt eine Dicke von 10 µm bis 500 µm, besonders bevorzugt von 30 µm bis 200 µm auf. Das ist besonders vorteilhaft im Hinblick auf die Stabilität und Verarbeitbarkeit der Trägerfolie.

Die elektrisch leitfähige Beschichtung enthält beispielsweise zumindest Silber, Zinkoxid, Indiumzinnoxid, Zinnoxid, Gallium, Gold, Kupfer, Wolfram und / oder Gemische davon. Die elektrisch leitfähige Beschichtung kann mehrere Einzelschichten umfassen, insbesondere zumindest eine metallische Schicht und dielektrische Schichten, die beispielsweise zumindest ein Metalloxid enthalten. Die elektrisch leitfähige Beschichtung weist bevorzugt eine Schichtdicke von 5 nm bis 1 µm, besonders bevorzugt von 10 nm bis 500 nm auf. Das ist besonders vorteilhaft im Hinblick auf die Transparenz der Verbundscheibe und die elektrisch Leitfähigkeit der Beschichtung.

Die transparente elektrisch leitfähige Beschichtung kann beispielsweise flächig auf die Außenscheibe oder die Innenscheibe oder eine Trägerfolie aufgebracht werden, bevorzugt durch Kathodenzerstäuben, Aufdampfen oder chemische Gasphasenabscheidung (chemical vapour deposition, CVD). Die zweite elektrisch leitfähige Struktur, welche die Schaltfläche ausbildet, wird durch Isolationsbereiche in der elektrisch leitfähigen Beschichtung erzeugt. Zwei kapazitiv gekoppelte Elektroden weisen dabei bevorzugt Leiterbahnen mit einer Breite von 5 µm bis 5 mm, besonders bevorzugt von 10 µm bis 2 mm auf. Die Isolationsbereiche weisen bevorzugt eine Breite von 5 µm bis 5 mm, besonders bevorzugt von 10 µm bis 2 mm auf. Damit werden besonders gute Ergebnisse erzielt. Die erste elektrisch leitfähige Struktur, welche den Antennenleiter bildet, kann beispielsweise ebenfalls durch Isolationsbereiche in der elektrisch leitfähigen Beschichtung erzeugt werden. Die Isolationsbereiche können durch Entfernung der Beschichtung beispielsweise durch Laserablation, mechanische Abrasion, Plasmaätzen oder nasschemische Verfahren in die elektrisch leitfähige Beschichtung eingebracht werden. Die Isolationsbereiche können alternativ durch Maskierungstechniken direkt beim Aufbringen der elektrisch leitfähigen Beschichtung bereitgestellt werden.

Der Vorteil einer flächig aufgebrachten leitfähigen Beschichtung mit Isolationsbereichen besteht darin, dass eine weitere Funktionalität der Beschichtung, beispielsweise reflektierende Eigenschaften im Infrarotbereich oder eine Heizfunktion, ausgenutzt werden können. Alternativ kann die leitfähige Beschichtung natürlich ausschließlich im Bereich der ersten und der zweiten elektrisch leitfähigen Struktur aufgebracht sein, beispielsweise durch Maskierungstechniken beim Aufbringen der Beschichtung oder durch Entfernung einer zunächst flächig aufgebrachten Beschichtung abseits der ersten und der zweiten elektrisch leitfähigen Struktur.

Die Außenscheibe und / oder die Innenscheibe enthalten bevorzugt vorgespanntes, teilvorgespanntes oder nichtvorgespanntes Glas, besonders bevorzugt Flachglas, Floatglas, Quarzglas, Borosilikatglas, Kalk-Natron-Glas, oder klare Kunststoffe, insbesondere Polyethylen, Polypropylen, Polycarbonat, Polymethylmethacrylat, Polystyrol, Polyamid, Polyester, Polyvinylchlorid und / oder Gemische davon.

Die Dicke der Außenscheibe und der Innenscheibe kann breit variieren und so hervorragend den Erfordernissen im Einzelfall angepasst werden. Die Außenscheibe und die Innenscheibe weisen bevorzugt eine Dicke von 0,5 mm bis 10 mm und besonders bevorzugt von 1 mm bis 5 mm auf.

Die Fläche der erfindungsgemäßen Verbundscheibe kann breit variieren und den Erfordernissen im Einzelfall angepasst werden, beispielsweise von 100 cm² bis 18 m². Die Verbundscheibe weist bevorzugt eine im Fahrzeugbau übliche Fläche für Windschutzscheiben, Seitenscheiben, Dachscheiben oder Heckscheiben von Kraftfahrzeugen auf, bevorzugt von 200 cm² bis zu 4 m².

Die erfindungsgemäße Verbundscheibe kann eine beliebige dreidimensionale Form aufweisen. Die Verbundscheibe ist bevorzugt plan oder leicht oder stark in einer Richtung oder in mehreren Richtungen des Raumes gebogen.

Die thermoplastische Zwischenschicht enthält bevorzugt zumindest einen thermoplastischen Kunststoff, wie Polyvinylbutyral (PVB), Polyethylenterephthalat (PET) und / oder Ethylenvinylacetat (EVA). Die thermoplastische Zwischenschicht wird bevorzugt durch eine thermoplastische Folie gebildet, über die die Außenscheibe und die Innenscheibe miteinander verbunden werden und die bevorzugt eine Dicke von 0,3 mm bis 0,9 mm aufweist. Die thermoplastische Zwischenschicht kann auch durch zwei oder mehrere solcher thermoplastischer Folien gebildet werden, zwischen denen beispielsweise eine Trägerfolie mit den erfindungsgemäßen elektrisch leitfähigen Strukturen angeordnet ist. Die Dicke der gesamten thermoplastischen Zwischenschicht beträgt bevorzugt von 0,3 mm bis 2 mm, besonders bevorzugt von 0,3 mm bis 1 mm.

Die erfindungsgemäße Verbundscheibe ist bevorzugt Teil einer Vorrichtung zum Öffnen und Schließen eines Cabriolet-Verdecks. Die Vorrichtung zum Öffnen und Schließen eines Cabriolet-Verdecks umfasst zumindest die folgenden Merkmale:
(a) eine erfindungsgemäße Verbundscheibe und
(b) eine Steuerungseinheit, wobei die Steuerungseinheit mit der zweiten elektrisch leitfähigen Struktur der Verbundscheibe elektrisch verbunden ist und beim Auslösen eines Schaltsignals über die Schaltfläche das Öffnen oder Schließen des Cabriolet-Verdecks einleitet.

Die erfindungsgemäße Verbundscheibe ist besonders bevorzugt die Windschutzscheibe des Cabriolets. Die Schaltfläche ist bevorzugt im in Einbaulage oberen Randbereich der Verbundscheibe angeordnet. Der Abstand des Mittelpunkts der Schaltfläche zur oberen Kante der Verbundscheibe beträgt besonders bevorzugt von 2 cm bis 20 cm, ganz besonders bevorzugt von 5 cm bis 10 cm. Durch die räumliche Nähe zum Cabriolet-Verdeck wird dadurch vorteilhaft eine intuitive Bedienung der Schaltfläche durch den Benutzer ermöglicht.

Die elektrische Verbindung der zweiten elektrisch leitfähigen Struktur mit der Steuerungseinheit erfolgt über einen Leiter, bevorzugt einen Flachleiter. Der Leiter wird bevorzugt vor dem Verbinden von erster und zweiter Scheibe zur Verbundscheibe mit der zweiten elektrisch leitfähigen Struktur verbunden. Nach Einbau der erfindungsgemäßen Verbundscheibe in das Cabriolet kann der Leiter mit der Steuerungseinheit und Spannungsversorgung verbunden werden. Die erste elektrisch leitfähige Struktur ist bevorzugt über einen Leiter mit einem Empfangsgerät verbunden.

Die Aufgabe der Erfindung wird weiter durch ein Verfahren zur Herstellung einer Verbundscheibe mit Antennenstruktur und integrierter Schaltfläche aus einer Außenscheibe, einer Innenscheibe und einer thermoplastischen Zwischenschicht gelöst, wobei zumindest (a) eine erste elektrisch leitfähige Struktur, die ein Antennenleiter ist, und eine zweite elektrisch leitfähige Struktur, die eine Schaltfläche ist, auf die Außenfläche der Außenscheibe, auf die Innenfläche der Außenscheibe, auf die Innenfläche der Innenscheibe, auf die Außenfläche der Innenscheibe oder auf die thermoplastische Zwischenschicht aufgebracht werden und (b) die Außenscheibe und die Innenscheibe über die thermoplastische Zwischenschicht zur Verbundscheibe verbunden werden.

Die thermoplastische Zwischenschicht kann in Form einer thermoplastischen Folie bereitgestellt werden. Die thermoplastische Zwischenschicht kann aber auch in Form mehrerer Folien, beispielsweise zweier thermoplastischen Folien und einer Trägerfolie bereitgestellt werden. Das Aufbringen der ersten und der zweiten elektrische leitfähigen Struktur auf die thermoplastische Zwischenschicht in Verfahrensschritt (b) beinhaltet dabei nur das Aufbringen der elektrisch leitfähigen Strukturen auf eine der Folien, beispielsweise auf die Trägerfolie, die in Verfahrenschritt (b) zwischen den beiden thermoplastischen Folien angeordnet wird.

Das Kontaktieren der ersten und der zweiten elektrisch leitfähigen Struktur mit Leitern, die dafür vorgesehen sind, die erste elektrisch leitfähige Struktur mit einem Empfangsgerät und die zweite elektrisch leitfähige Struktur mit einer Steuerungselektronik zu verbinden, erfolgt bevorzugt zwischen Verfahrensschritt (a) und Verfahrensschritt (b).

Das Verbinden der ersten und der zweiten Scheibe in Verfahrensschritt (b) erfolgt bevorzugt bei Temperaturen von 120 °C bis 170 °C, einem Druck von 10 bar bis 15 bar und für einen Zeitraum von 30 min bis 240 min.

Die Erfindung umfasst außerdem die Verwendung der Verbundscheibe mit Antennenstruktur und integrierter Schaltfläche als funktionales und / oder dekoratives Einzelstück, als Einbauteil in Möbeln und Geräten, als Verglasung von Gebäuden, insbesondere im Zugangs- oder Fensterbereich. Die Verbundscheibe mit Antennenstruktur und integrierter Schaltfläche wird bevorzugt in Fortbewegungsmitteln für den Verkehr auf dem Lande, in der Luft oder zu Wasser verwendet, besonders bevorzugt als Heckscheibe, Seitenscheibe, Dachscheibe oder Windschutzscheibe eines Kraftfahrzeugs, ganz besonders bevorzugt als Windschutzscheibe eines Cabriolets, eines Coupes, eines Roadsters oder eines Targas.

Die Erfindung wird anhand einer Zeichnung und Ausführungsbeispielen näher erläutert. Die Zeichnung ist eine schematische Darstellung und nicht maßstabsgetreu. Die Zeichnung schränkt die Erfindung in keiner Weise ein. Es zeigen:
- Fig. 1: eine Draufsicht auf eine erste Ausgestaltung der erfindungsgemäßen Verbundscheibe mit Antennenstruktur und integrierter Schaltfläche,
- Fig. 2: eine Draufsicht auf eine weitere Ausgestaltung der erfindungsgemäßen Verbundscheibe mit Antennenstruktur und integrierter Schaltfläche,
- Fig. 3: einen Schnitt A-A' durch die Verbundscheibe gemäß Figur 1,
- Fig. 4: einen Schnitt B-B' durch die Verbundscheibe gemäß Figur 2,
- Fig. 5: einen Schnitt B-B' durch eine alternative Ausgestaltung der erfindungsgemäßen Verbundscheibe,
- Fig. 6: ein Ausführungsbeispiel des erfindungsgemäßen Verfahrens anhand eines Flussdiagramms,
- Fig. 7: ein weiteres Ausführungsbeispiel des erfindungsgemäßen Verfahrens anhand eines Flussdiagramms und
- Fig. 8: ein weiteres Ausführungsbeispiel des erfindungsgemäßen Verfahrens anhand eines Flussdiagramms.

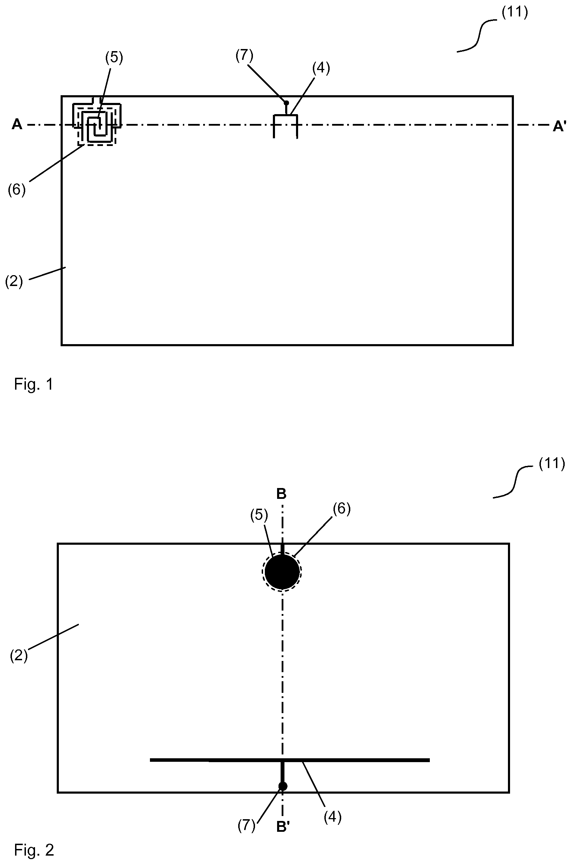

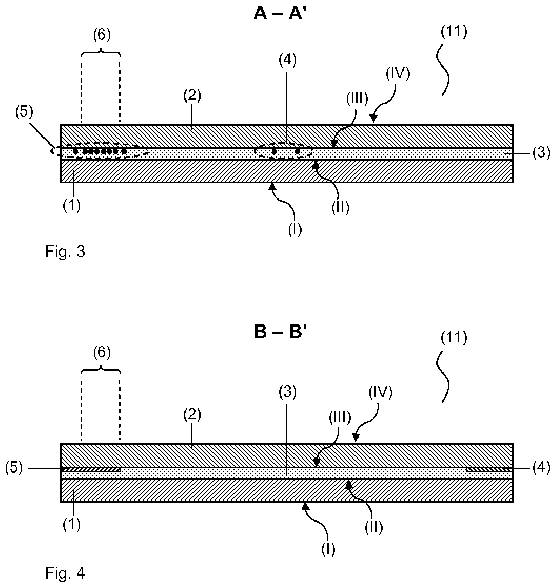

Fig. 1 und Fig. 3 zeigen je ein Detail einer erfindungsgemäßen Verbundscheibe 11 mit Antennenstruktur und integrierter Schaltfläche. Die Verbundscheibe 11 weist eine Breite von 150 cm und eine Höhe von 90 cm auf und ist als Windschutzscheibe eines Cabriolets vorgesehen. Die Verbundscheibe 11 umfasst eine Außenscheibe 1 und eine Innenscheibe 2, die über eine thermoplastische Zwischenschicht 3 miteinander verbunden sind. Die Außenscheibe 1 und die Innenscheibe 2 enthalten Natron-Kalk-Glas und weisen eine Dicke von 2,1 mm auf. Die thermoplastischen Zwischenschicht 3 enthält Polyvinylbutyral (PVB) und weist eine Dicke von 0,76 mm auf. Die Innenfläche (II) der Außenscheibe 1 und die Innenfläche (III) der Innenscheibe 2 sind zur thermoplastischen Zwischenschicht 3 hingewandt. Die Außenfläche (I) der Außenscheibe 1 und die Außenfläche (IV) der Innenscheibe 2 sind von der thermoplastischen Zwischenschicht 3 weggewandt.

In die thermoplastische Zwischenschicht 3 sind eine erste elektrisch leitfähige Struktur 4 und eine zweite elektrisch leitfähige Struktur 5 eingelagert. Die erste elektrisch leitfähige Struktur 4 und die zweite elektrisch leitfähige Struktur 5 sind durch Drähte realisiert, welche Wolfram enthalten und eine Dicke von 80 µm aufweisen. Aufgrund der vorteilhaft geringen Dicke der Drähte sind die elektrisch leitfähigen Strukturen 4, 5 für den Betrachter kaum wahrnehmbar.

Die erste elektrisch leitfähige Struktur 4 bildet einen Antennenleiter aus. Der Antennenleiter erstreckt sich bis zum Bereich der oberen Kante der Verbundscheibe, wo er einen Anschlusspunkt 7 aufweist. Über den Anschlusspunkt 7 ist der Antennenleiter kapazitiv mit einem nicht dargestellten Leiter zum Empfangsgerät verbunden.

Die zweite elektrisch leitfähige Struktur 5 umfasst zwei Drähte, wobei jeder Draht eine Elektrode ausbildet. In einem etwa quadratischen Bereich mit einer Kantenlänge von 5 cm sind die Drähte mäanderartig mit einem Abstand von 1 mm umeinander angeordnet und kapazitiv miteinander gekoppelt sind. In diesem Bereich bildet die zweite elektrisch leitfähige Struktur 5 eine kapazitive Schaltfläche 6 aus. Jeder Draht der zweiten elektrisch leitfähigen Struktur 5 verläuft bis zur oberen Kante der Verbundscheibe 11 und ist dort mit einem nicht dargestellten Flachleiter verlötet. Über die Flachleiter ist die zweite elektrisch leitfähige Struktur 5 mit einer nicht dargestellten externen Spannungsversorgung und Steuerungselektronik verbunden. Nähert sich ein Körper, beispielsweise ein menschlicher Finger der zweiten elektrisch leitfähigen Struktur 5 im Bereich der Schaltfläche 6, so ändert sich die Kapazität des durch die zweite elektrisch leitfähige Struktur 5 gebildeten Kondensators. Die Steuerungselektronik kann die Kapazitätsänderung messen und bei Überschreitung eines Schwellwertes ein Schaltsignal auslösen. Die Schaltfläche 6 ist in dem gezeigten Ausführungsbeispiel dafür vorgesehen, das Öffnen oder Schließen des Cabriolet-Verdecks einzuleiten.

Der Mittelpunkt der Schaltfläche 6 ist in einem Abstand zur oberen Kante der Verbundscheibe 11 von 7 cm und in einem Abstand zur linken Kante der Verbundscheibe 11 von 10 cm angeordnet. Durch die Anordnung der Schaltfläche 6 im Randbereich der Verbundscheibe 11 wird die Transparenz des Sichtbereichs nicht gestört, beispielsweise durch eine nicht dargestellte Markierung der Schaltfläche 6 oder durch Fingerabdrücke im Bereich der Schaltfläche 6. Die Anordnung der Schaltfläche 6 im Bereich der oberen Kante der Verbundscheibe 11 und damit in Einbaulage nahe des Cabriolet-Verdecks ermöglicht zudem eine intuitive Bedienung der Schaltfläche 6 zum Öffnen oder Schließen des Cabriolet-Verdecks.

Da ein Cabriolet-Verdeck nicht zur Anbringung von Antennen genutzt werden kann, sind Antennenstrukturen typischerweise wie in dem Ausführungsbeispiel für den Betrachter nicht oder kaum sichtbar in die Windschutzscheibe von Cabriolets integriert. Die Schaltfläche 6 wird durch die zweite elektrisch leitfähige Struktur 5 ausgebildet, die wie die Antennenstruktur in der thermoplastischen Zwischenschicht 3 eingelagert ist und nach dem gleichen technischen Prinzip realisiert ist wie die Antennenstruktur, in dem Ausführungsbeispiel durch in die thermoplastische Zwischenschicht 3 eingelagerte dünne Drähte. Dadurch kann die zweite elektrisch leitfähige Struktur 5 mit geringem technischen und finanziellen Mehraufwand in die Verbundscheibe 11 eingebracht werden. Das ist ein großer Vorteil der vorliegenden Erfindung. Durch die Nähe der Schaltfläche 6 zum Cabriolet-Verdeck ist zudem, verglichen mit einem herkömmlichen Schalter am Armaturenbrett, eine intuitivere Bedienung der Schaltfläche 6 zum Öffnen und Schließen des Cabriolet-Verdecks möglich. Das ist ein weiterer großer Vorteil der vorliegenden Erfindung.

Fig. 2 und Fig. 4 zeigen je ein Detail einer alternative Ausgestaltung der erfindungsgemäßen Verbundscheibe 11. Die erste elektrisch leitfähige Struktur 4 und die zweite elektrisch leitfähige Struktur 5 sind mittels Siebdruck auf die Innenfläche (III) der Innenscheibe 2 aufgedruckt, enthalten Silber und Glasfritten und weisen eine Dicke von 10 µm auf. Durch die Anordnung des Silberdrucks auf der Innenfläche einer Scheibe sind die elektrisch leitfähigen Strukturen 4, 5 vorteilhaft vor Beschädigungen, beispielsweise durch mechanischen Abrieb bei Berührung oder Korrosion, geschützt. Die zweite elektrisch leitfähige Struktur 5 bildet im Bereich der Schaltfläche 6 eine Flächenelektrode, welche in Form einer Kreisfläche mit einem Radius von 2 cm ausgeformt ist. Der Abstand des Mittelpunktes der Schaltfläche 6 zur oberen Kante der Verbundscheibe 11 beträgt 10 cm. Entlang der horizontalen Ausdehnung der Verbundscheibe 11 ist die Schaltfläche 6 mittig angeordnet. Der besondere Vorteil liegt darin, dass die Schaltfläche 6 gleichermaßen für den Fahrer wie für den Beifahrer des Cabriolets zugänglich ist. Die Schaltfläche 6 ist außerhalb des Sichtbereichs der Verbundscheibe angeordnet, so dass die Durchsicht nicht durch die aufgedruckte zweite elektrisch leitfähige Struktur 5 gestört wird. Ein linienförmiger Bereich der zweiten elektrisch leitfähigen Struktur 5 mit einer Breite von 1 mm verläuft von der Flächenelektrode zur oberen Kante der zweiten Scheibe 2 und ist dort mit einem nicht dargestellten Flachleiter elektrisch verbunden. Eine ebenfalls nicht dargestellte externe Steuerungselektronik, die mit dem Flachleiter verbunden ist, kann eine Kapazitätsänderung der Flächenelektrode gegen Erde messen, die beispielsweise durch die Annäherung eines Fingers hervorgerufen wird, und ein Schaltsignal auslösen.

Fig. 3 zeigt einen Schnitt entlang A-A' durch die erfindungsgemäße Verbundscheibe 11 gemäß Figur 1. Zu sehen sind die Außenscheibe 1, die Innenscheibe 2, die thermoplastischen Zwischenschicht 3 und die darin eingelagerten Drähte als erste elektrisch leitfähige Struktur 4 und zweite elektrisch leitfähige Struktur 5. Die zweite elektrisch leitfähige Struktur 5 bildet die kapazitive Schaltfläche 6 aus.

Fig. 4 zeigt einen Schnitt entlang B-B' durch die erfindungsgemäße Verbundscheibe 11 gemäß Figur 2. Zu sehen sind die Außenscheibe 1, die Innenscheibe 2 und die thermoplastische Zwischenschicht 3. Zu sehen sind weiter die auf die Innenfläche (III) der Innenscheibe 2 aufgedruckten elektrisch leitfähigen Strukturen 4, 5. Die zweite elektrisch leitfähige Struktur 5 bildet die Schaltfläche 6 aus.

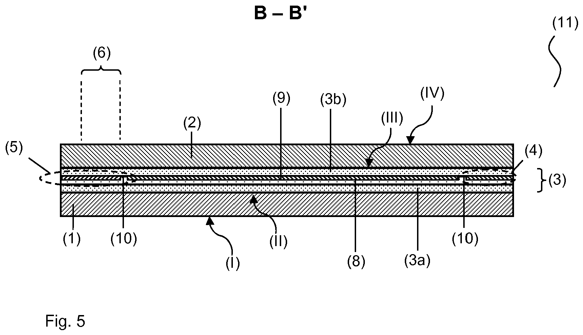

Fig. 5 zeigt einen Schnitt entlang B-B' durch eine alternative Ausgestaltung der erfindungsgemäßen Verbundscheibe 11. Die thermoplastische Zwischenschicht 3 umfasst eine erste thermoplastische Folie 3a und eine zweite thermoplastische Folie 3b, zwischen denen eine Trägerfolie 8 angeordnet ist. Die thermoplastischen Folien 3a, 3b enthalten PVB und weisen eine Dicke von 0,38 mm auf. Die Trägerfolie 8 enthält Polyethylenterephthalat (PET) und weist eine Dicke von 0,2 mm auf. Auf eine Oberfläche der Trägerfolie 8 ist mittels Kathodenzerstäuben eine transparente elektrisch leitfähige Beschichtung 9 aufgebracht. Die Beschichtung 9 enthält alternierend Silberschichten und dielektrische Schichten und weist eine Dicke von 200 nm sowie reflektierende Eigenschaften im Infrarotbereich auf. Durch mittels Laserablation entschichtete Isolationsbereiche 10 mit einer Breite von 0,1 mm innerhalb der Beschichtung 9 sind die erste elektrisch leitfähige Struktur 4 und die zweite elektrisch leitfähige Struktur 5 von der übrigen Beschichtung 9 getrennt.

Die transparente elektrisch leitfähige Beschichtung 9 mit den Isolationsbereichen 10 kann in alternativen Ausgestaltungen statt auf einer Trägerfolie 8 auf einer Oberfläche, bevorzugt einer Innenfläche einer Scheibe 1, 2 aufgebracht sein.

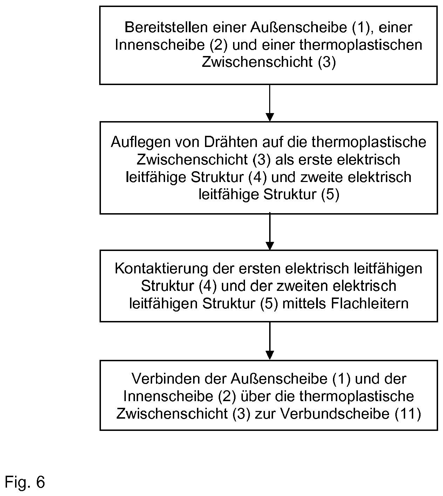

Fig. 6 zeigt ein Flussdiagramm eines Ausführungsbeispiels des erfindungsgemäßen Verfahrens zur Herstellung einer Verbundscheibe 11 mit Antennenstruktur und integrierter Schaltfläche.

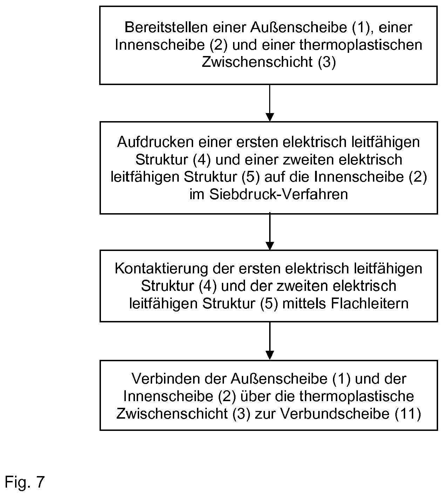

Fig. 7 zeigt ein Flussdiagramm eines weiteren Ausführungsbeispiels des erfindungsgemäßen Verfahrens zur Herstellung einer Verbundscheibe 11 mit Antennenstruktur und integrierter Schaltfläche.

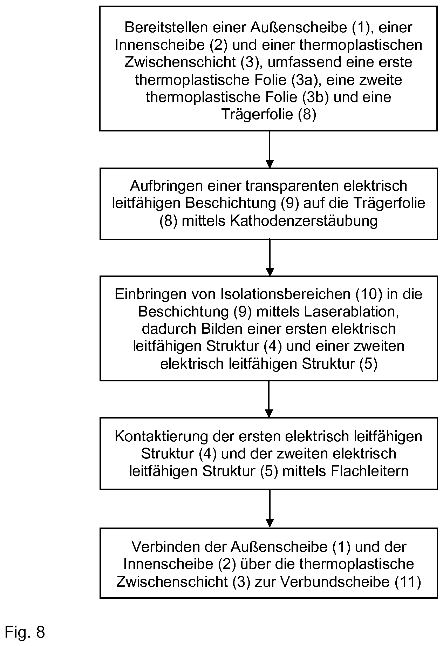

Fig. 8 zeigt ein Flussdiagramm eines weiteren Ausführungsbeispiels des erfindungsgemäßen Verfahrens zur Herstellung einer Verbundscheibe 11 mit Antennenstruktur und integrierter Schaltfläche.

Es war für den Fachmann unerwartet und überraschend, dass auf einfache und kostengünstige Weise eine Schaltfläche 6 in eine Verbundscheibe 11 mit Antennenstruktur integriert werden kann.

### Bezugszeichenliste:

- (1): Außenscheibe
- (2): Innenscheibe
- (3): thermoplastische Zwischenschicht
- (3a): erste thermoplastische Folie
- (3b): zweite thermoplastische Folie
- (4): erste elektrisch leitfähige Struktur / Antennenleiter
- (5): zweite elektrisch leitfähige Struktur
- (6): Schaltfläche
- (7): Anschlusspunkt von (4)
- (8): Trägerfolie
- (9): transparente elektrisch leitfähige Beschichtung
- (10): Isolationsbereiche in (9)
- (11): Verbundscheibe mit Antennenstruktur und integrierter Schaltfläche

- (I): Außenfläche von (1)
- (II): Innenfläche von (1)
- (III): Innenfläche von (2)
- (IV): Außenfläche von (2)

- A-A': Schnittlinie
- B-B': Schnittlinie

## Patentansprüche

1. Verbundscheibe (11) mit Antennenstruktur und integrierter Schaltfläche aus einer Außenscheibe (1) mit einer Außenfläche (I) und einer Innenfläche (II), einer Innenscheibe (2) mit einer Innenfläche (III) und einer Außenfläche (IV) und einer thermoplastischen Zwischenschicht (3), mindestens umfassend:
- eine erste elektrisch leitfähige Struktur (4), die ein Antennenleiter ist, und
- eine zweite elektrisch leitfähige Struktur (5), die eine Schaltfläche (6) ist, und wobei die zweite elektrisch leitfähige Struktur (5) als Antennenleiter dient,
wobei die erste elektrisch leitfähige Struktur (4) und die zweite elektrisch leitfähige Struktur (5) auf der Außenscheibe (1) auf der Außenfläche (I), auf der Innenfläche (II), auf der Innenscheibe (2) auf der Innenfläche (III), auf der Außenfläche (IV) oder in der thermoplastischen Zwischenschicht (3) angeordnet sind und als Drähte, als aufgedruckte leitfähige Strukturen oder als transparente leitfähige Beschichtungen ausgebildet sind.

2. Verbundscheibe (11) nach Anspruch 1, wobei die erste elektrisch leitfähige Struktur (4) und die zweite elektrisch leitfähige Struktur (5) als Drähte ausgebildet sind, die in die thermoplastische Zwischenschicht (3) eingelagert sind und die bevorzugt zumindest Kupfer, Wolfram, Gold, Silber, Aluminium, Nickel, Mangan, Chrom und / oder Eisen und / oder Gemische und / oder Legierungen davon enthalten und die bevorzugt eine Dicke von 10 µm bis 300 µm, besonders bevorzugt von 20 µm bis 150 µm aufweisen.

3. Verbundscheibe (11) nach Anspruch 1, wobei die erste elektrisch leitfähige Struktur (4) und die zweite elektrisch leitfähige Struktur (5) als aufgedruckte leitfähige Strukturen ausgebildet sind, die zumindest Silber, bevorzugt Silberpartikel und Glasfritten enthalten und die bevorzugt eine Schichtdicke von 5 µm bis 40 µm, besonders bevorzugt von 8 µm bis 20 µm, ganz besonders bevorzugt von 10 µm bis 15 µm aufweisen und die bevorzugt auf der Außenscheibe (1) auf der Innenfläche (II) oder auf der Innenscheibe (2) auf der Innenfläche (III) aufgedruckt sind.

4. Verbundscheibe (11) nach Anspruch 1, wobei die erste elektrisch leitfähige Struktur (4) und die zweite elektrisch leitfähige Struktur (5) als transparente leitfähige Beschichtungen ausgestaltet sind, die eine Dicke von 5 nm bis 1 µm, bevorzugt von 10 nm bis 500 nm aufweist und die bevorzugt zumindest Silber, Zinkoxid, Indiumzinnoxid, Zinnoxid, Gallium, Gold, Kupfer, Wolfram und / oder Gemische enthält.

5. Verbundscheibe (11) nach Anspruch 4, wobei die transparente leitfähige Beschichtung auf der Außenscheibe (1) auf der Innenseite (II) oder auf der Innenscheibe (2) auf der Innenseite (III) oder auf einer Trägerfolie (8) in der thermoplastischen Zwischenschicht (3) aufgebracht ist.

6. Verbundscheibe (11) nach einem der Ansprüche 1 bis 5, wobei die erste elektrisch leitfähige Struktur (4) mit zumindest einem Leiter, bevorzugt einem Flachleiter galvanisch oder kapazitiv verbunden ist und die zweite elektrisch leitfähige Struktur (5) mit zumindest einem Leiter, bevorzugt einem Flachleiter galvanisch verbunden ist.

7. Verbundscheibe (11) nach einem der Ansprüche 1 bis 6, wobei die Schaltfläche (6) eine Fläche von 0,5 cm² bis 100 cm², bevorzugt von 1 cm² bis 25 cm² aufweist.

8. Verbundscheibe (11) nach einem der Ansprüche 1 bis 7, wobei der Mittelpunkt der Schaltfläche (6) einen Abstand von 2 cm bis 20 cm, bevorzugt von 5 cm bis 10 cm zu zumindest einer Kante der Verbundscheibe (11), bevorzugt zur oberen Kante der Verbundscheibe (11) aufweist.

9. Verbundscheibe (11) nach einem der Ansprüche 1 bis 8, wobei die Außenscheibe (1) und / oder die Innenscheibe (2) zumindest Glas, bevorzugt Flachglas, Floatglas, Quarzglas, Borosilikatglas, Kalk-Natron-Glas, oder klare Kunststoffe, insbesondere Polyethylen, Polypropylen, Polycarbonat, Polymethylmethacrylat, Polystyrol, Polyamid, Polyester, Polyvinylchlorid und / oder Gemische davon, enthalten.

10. Verbundscheibe (11) nach einem der Ansprüche 1 bis 9, wobei die thermoplastische Zwischenschicht (3) zumindest Polyvinylbutyral (PVB), Polyethylenterephthalat (PET) und / oder Ethylenvinylacetat (EVA) enthält.

11. Vorrichtung zum Öffnen und Schließen eines Cabriolet-Verdecks, mindestens umfassend:
- eine Verbundscheibe (11) nach einem der Ansprüche 1 bis 10 und
- eine Steuerungseinheit, wobei die Steuerungseinheit mit der zweiten elektrisch leitfähigen Struktur (5) elektrisch verbunden ist und beim Auslösen eines Schaltsignals über die Schaltfläche (6) das Öffnen oder Schließen des Cabriolet-Verdecks einleitet.

12. Verfahren zur Herstellung einer Verbundscheibe (11) mit Antennenstruktur und integrierter Schaltfläche nach einem der Ansprüche 1 bis 10, wobei zumindest
(a) eine erste elektrisch leitfähige Struktur (4), die ein Antennenleiter ist, und eine zweite elektrisch leitfähige Struktur (5), die eine Schaltfläche (6) ist, auf die Außenscheibe (1) auf die Außenfläche (I), auf die Innenfläche (II), auf die Innenscheibe (2) auf die Innenfläche (III), auf die Außenfläche (IV) oder auf die thermoplastische Zwischenschicht (3) aufgebracht werden und
(b) die Außenscheibe (1) und die Innenscheibe (2) über die thermoplastische Zwischenschicht (3) zur Verbundscheibe (11) verbunden werden.

13. Verfahren nach Anspruch 12, wobei vor Verfahrensschritt (b) die erste elektrisch leitfähige Struktur (4) mit einem Leiter galvanisch oder kapazitiv verbunden wird und die zweite elektrisch leitfähige Struktur (5) mit zumindest einem weiteren Leiter galvanisch verbunden wird.

14. Verwendung einer Verbundscheibe (11) mit Antennenstruktur (4) und integrierter Schaltfläche (6) gemäß einem der Ansprüche 1 bis 10 in Fortbewegungsmitteln für den Verkehr auf dem Lande, in der Luft oder zu Wasser, bevorzugt als Heckscheibe, Seitenscheibe, Dachscheibe oder Windschutzscheibe eines Kraftfahrzeugs, ganz besonders bevorzugt als Windschutzscheibe eines Cabriolets oder eines Coupes.

## Claims

1. Composite pane (11) with an antenna structure and an integrated switching surface comprising an outer pane (1) with an outer surface (I) and an inner surface (II), an inner pane (2) with an inner surface (III) and an outer surface (IV), and a thermoplastic intermediate layer (3), at least comprising:
- a first electrically conductive structure (4) which is an antenna conductor, and
- a second electrically conductive structure (5) which is a switching surface (6), and
wherein the second electrically conductive structure (5) serves as an antenna conductor, wherein the first electrically conductive structure (4) and the second electrically conductive structure (5) are arranged on the outer pane (1) on the outer surface (I), on the inner surface (II), on the inner pane (2) on the inner surface (III), on the outer surface (IV) or in the thermoplastic intermediate layer (3) and are formed as wires, as printed conductive structures or as transparent conductive coatings.

2. Composite pane (11) according to claim 1, wherein the first electrically conductive structure (4) and the second electrically conductive structure (5) are formed as wires which are embedded in the thermoplastic intermediate layer (3) and which preferably contain at least copper, tungsten, gold, silver, aluminium, nickel, manganese, chromium and/or iron and/or mixtures and/or alloys thereof and which preferably have a thickness of 10 µm to 300 µm, particularly preferably of 20 µm to 150 µm.

3. Composite pane (11) according to claim 1, wherein the first electrically conductive structure (4) and the second electrically conductive structure (5) are formed as printed conductive structures which contain at least silver, preferably silver particles and glass frits and which preferably have a layer thickness of 5 µm to 40 µm, particularly preferably of 8 µm to 20 µm, very particularly preferably of 10 µm to 15 µm, and which are preferably printed on the outer pane (1) on the inner surface (II) or the inner surface (III).

4. Composite pane (11) according to claim 1, wherein the first electrically conductive structure (4) and the second electrically conductive structure (5) are designed as transparent conductive coatings which have a thickness of 5 nm to 1 µm, preferably from 10 nm to 500 nm, and which preferably contain at least silver, zinc oxide, indium tin oxide, tin oxide, gallium, gold, copper, tungsten and/or mixtures.

5. Composite pane (11) according to claim 4, wherein the transparent conductive coating is applied to the outer pane (1) on the inner side (II) or on the inner pane (2) on the inner side (III) or to a carrier film (8) in the thermoplastic intermediate layer (3).

6. Composite pane (11) according to one of claims 1 to 5, wherein the first electrically conductive structure (4) is galvanically or capacitively connected to at least one conductor, preferably a flat conductor, and the second electrically conductive structure (5) is galvanically connected to at least one conductor, preferably a flat conductor.

7. Composite pane (11) according to one of claims 1 to 6, wherein the surface area (6) has an area of 0.5 cm² to 100 cm², preferably of 1 cm² to 25 cm².

8. Composite pane (11) according to one of claims 1 to 7, wherein the centre of the surface area (6) has a distance of 2 cm to 20 cm, preferably of 5 cm to 10 cm, from at least one edge of the composite pane (11), preferably from the upper edge of the composite pane (11).

9. Composite pane (11) according to one of claims 1 to 8, wherein the outer pane (1) and/or the inner pane (2) contains at least glass, preferably flat glass, float glass, quartz glass, borosilicate glass, soda-lime glass, or clear plastics, in particular polyethylene, polypropylene, polycarbonate, polymethyl methacrylate, polystyrene, polyamide, polyester, polyvinyl chloride and/or mixtures thereof.

10. The composite pane (11) according to one of claims 1 to 9, wherein the thermoplastic intermediate layer (3) contains at least polyvinyl butyral (PVB), polyethylene terephthalate (PET) and/or ethylene vinyl acetate (EVA).

11. Device for opening and closing a convertible top, at least comprising:
- a composite pane (11) according to any one of claims 1 to 10 and
- a control unit, the control unit being electrically connected to the second electrically conductive structure (5) and initiating the opening or closing of the convertible top when a switching signal is triggered via the switching surface (6).

12. Method for producing a composite pane (11) with an antenna structure and an integrated switching surface according to one of claims 1 to 10, wherein at least
(a) a first electrically conductive structure (4), which is an antenna conductor, and a second electrically conductive structure (5), which is a switching surface (6), are applied to the outer pane (1) on the outer surface (I), on the inner surface (II), on the inner pane (2) on the inner surface (III), on the outer surface (IV) or on the thermoplastic intermediate layer (3), and
(b) the outer pane (1) and the inner pane (2) are joined to form the composite pane (11) via the thermoplastic intermediate layer (3).

13. Method according to claim 12, wherein before method step (b) the first electrically conductive structure (4) is galvanically or capacitively connected to a conductor and the second electrically conductive structure (5) is galvanically connected to at least one further conductor.

14. Use of a composite pane (11) with an antenna structure (4) and integrated switching surface (6) according to one of claims 1 to 10 in means of locomotion for traffic on land, in the air or on water, preferably as a rear window, side window, roof window or windscreen of a motor vehicle, very preferably as a windscreen of a convertible or a coupe.

## Revendications

1. Vitre composite (11) avec une structure d'antenne et une surface de commutation intégrée comprenant une vitre extérieure (1) avec une surface extérieure (I) et une surface intérieure (II), une vitre intérieure (2) avec une surface intérieure (III) et une surface extérieure (IV), et une couche intermédiaire thermoplastique (3), comprenant au moins :
- une première structure électriquement conductrice (4) qui est un conducteur d'antenne, et
- une deuxième structure électriquement conductrice (5) qui est une surface de commutation (6), et dans laquelle la deuxième structure électriquement conductrice (5) sert de conducteur d'antenne,
dans laquelle la première structure électriquement conductrice (4) et la deuxième structure électriquement conductrice (5) sont disposées sur la vitre extérieure (1) sur la surface extérieure (I), sur la surface intérieure (II), sur la vitre intérieure (2) sur la surface intérieure (III), sur la surface extérieure (IV) ou dans la couche intermédiaire thermoplastique (3) et sont formées comme des fils, comme des structures conductrices imprimées ou comme des revêtements conducteurs transparents.

2. Vitre composite (11) selon la revendication 1, dans laquelle la première structure électriquement conductrice (4) et la deuxième structure électriquement conductrice (5) sont réalisées sous forme de fils qui sont noyés dans la couche intermédiaire thermoplastique (3) et qui contiennent de préférence au moins du cuivre, du tungstène, de l'or, de l'argent, de l'aluminium, du nickel, du manganèse, du chrome et/ou du fer et/ou des mélanges et/ou des alliages de ceux-ci et qui ont de préférence une épaisseur de 10 µm à 300 µm, de préférence de 20 µm à 150 µm.

3. Vitre composite (11) selon la revendication 1, dans laquelle la première structure électriquement conductrice (4) et la deuxième structure électriquement conductrice (5) sont réalisées sous la forme de structures conductrices imprimées qui contiennent au moins de l'argent, de préférence des particules d'argent et des frittes de verre et qui présentent de préférence une épaisseur de couche de 5 µm à 40 µm, particulièrement de 8 µm à 20 µm, très particulièrement de 10 µm à 15 µm, et qui sont de préférence imprimées sur la vitre extérieure (1) sur la surface intérieure (II) ou la surface intérieure (III).

4. Vitre composite (11) selon la revendication 1, dans laquelle la première structure électriquement conductrice (4) et la deuxième structure électriquement conductrice (5) sont conçues comme des revêtements conducteurs transparents qui ont une épaisseur de 5 nm à 1 µm, de préférence de 10 nm à 500 nm, et qui contiennent de préférence au moins de l'argent, de l'oxyde de zinc, de l'oxyde d'indium et d'étain, de l'oxyde d'étain, du gallium, de l'or, du cuivre, du tungstène et/ou des mélanges.

5. Vitre composite (11) selon la revendication 4, dans laquelle le revêtement conducteur transparent est appliqué sur la vitre extérieure (1) sur la face intérieure (II) ou sur la vitre intérieure (2) sur la face intérieure (III) ou sur un film support (8) dans la couche intermédiaire thermoplastique (3).

6. Vitre composite (11) selon l'une des revendications 1 à 5, dans laquelle la première structure électriquement conductrice (4) est reliée de manière galvanique ou capacitive à au moins un conducteur, de préférence un conducteur plat, et la deuxième structure électriquement conductrice (5) est reliée de manière galvanique à au moins un conducteur, de préférence un conducteur plat.

7. Vitre composite (11) selon l'une des revendications 1 à 6, dans laquelle la surface (6) a une superficie de 0,5 cm² à 100 cm², de préférence de 1 cm² à 25 cm².

8. Vitre composite (11) selon l'une des revendications 1 à 7, dans laquelle le centre de la surface (6) présente une distance de 2 cm à 20 cm, de préférence de 5 cm à 10 cm, par rapport à au moins un bord de la vitre composite (11), de préférence par rapport au bord supérieur de la vitre composite (11).

9. Vitre composite (11) selon l'une des revendications 1 à 8, la vitre extérieure (1) et/ou la vitre intérieure (2) contenant au moins du verre, de préférence du verre plat, du verre flotté, du verre de quartz, du verre borosilicaté, du verre sodocalcique ou des matières plastiques transparentes, en particulier du polyéthylène, du polypropylène, du polycarbonate, du polyméthacrylate de méthyle, du polystyrène, du polyamide, du polyester, du chlorure de polyvinyle et/ou des mélanges de ceux-ci.

10. Vitre composite (11) selon l'une des revendications 1 à 9, dans laquelle la couche intermédiaire thermoplastique (3) contient au moins du polyvinylbutyral (PVB), du polyéthylène téréphtalate (PET) et/ou de l'éthylène acétate de vinyle (EVA).

11. Dispositif d'ouverture et de fermeture d'une capote de cabriolet, comprenant au moins :
- une vitre composite (11) selon l'une quelconque des revendications 1 à 10 et
- une unité de commande, l'unité de commande étant reliée électriquement à la deuxième structure électriquement conductrice (5) et déclenchant l'ouverture ou la fermeture du toit convertible lorsqu'un signal de commutation est déclenché par la surface de commutation (6).

12. Procédé de fabrication d'une vitre composite (11) avec une structure d'antenne et une surface de commutation intégrée selon l'une des revendications 1 à 10, dans lequel au moins
a) une première structure électriquement conductrice (4), qui est un conducteur d'antenne, et une deuxième structure électriquement conductrice (5), qui est une surface de commutation (6), sont appliquées sur la vitre extérieure (1) sur la surface extérieure (I), sur la surface intérieure (II), sur la vitre intérieure (2) sur la surface intérieure (III), sur la surface extérieure (IV) ou sur la couche intermédiaire thermoplastique (3), et
b) la vitre extérieure (1) et la vitre intérieure (2) sont assemblées pour former la vitre composite (11) via la couche intermédiaire thermoplastique (3).

13. Procédé selon la revendication 12, dans lequel, avant l'étape de procédé (b), la première structure électriquement conductrice (4) est reliée par voie galvanique ou capacitive à un conducteur et la deuxième structure électriquement conductrice (5) est reliée par voie galvanique à au moins un autre conducteur.

14. Utilisation d'une vitre composite (11) avec une structure d'antenne (4) et une surface de commutation intégrée (6) selon l'une des revendications 1 à 10 dans des moyens de locomotion pour la circulation sur terre, dans l'air ou sur l'eau, de préférence comme vitre arrière, vitre latérale, fenêtre de toit ou pare-brise d'un véhicule automobile, de préférence comme pare-brise d'un cabriolet ou d'un coupé.
